Europäisches Patentamt

European Patent Office

Office européen des brevets

(11) Publication number: **0 121 096 B1**

# EUROPEAN PATENT SPECIFICATION

(45) Date of publication of patent specification: **04.01.89**

(21) Application number: **84102100.9**

(22) Date of filing: **29.02.84**

(51) Int. Cl.⁴: **H 01 L 29/08, H 01 L 27/08**

(54) Semiconductor contact structure.

(30) Priority: **31.03.83 US 481023**

(43) Date of publication of application:
**10.10.84 Bulletin 84/41**

(45) Publication of the grant of the patent:
**04.01.89 Bulletin 89/01**

(84) Designated Contracting States:
**DE FR GB**

(56) References cited:
**EP-A-0 009 782**
**DE-A-2 625 917**
**JP-A-56 054 071**

**PATENTS ABSTRACTS OF JAPAN, vol. 6, no.
147 (E-123)1025r, 6th August 1982; & JP - A - 57
711 69 (NIPPON DENKI K.K.) 01-05-1982
IDEM**

The file contains technical information
submitted after the application was filed and
not included in this specification

(73) Proprietor: **International Business Machines
Corporation
Old Orchard Road
Armonk, N.Y. 10504 (US)**

(72) Inventor: **Bakeman, Paul Evans, Jr.
RD 3 Box 3100 Harbor Road
Shelburne Vermont 05482 (US)**
Inventor: **Geipel, Henry John, Jr.
1 Alderbrook Road
Essex Junction Vermont 05452 (US)**

(74) Representative: **Mönig, Anton, Dipl.-Ing.
IBM Deutschland GmbH Schönaicher Strasse
220
D-7030 Böblingen (DE)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

This invention relates in general to integrated circuits. More specifically, it relates to a new contact design suitable for use in a field effect transistor structure, particularly in a complementary type MOS ("CMOS") circuit arrangement to prevent latch-up in the device.

CMOS circuits are preferred for many applications for, among other advantages, their low power dissipation. They use a combination of N-channel and P-channel MOS transistors monolithically constructed on the same substrate in a circuit arrangement that consumes no DC power. They consume significant power only during AC switching with their power use increasing with the operating frequency. However, the expansion of applications of CMOS circuits in bulk silicon substrates has been hindered to a certain extent by the susceptibility of CMOS circuits to an effect which is known as the latch-up effect, which is due to the SCR action of the parasitic bipolar transistors inherent in CMOS structures constructed in bulk silicon. For example, in a CMOS circuit having a P-channel Field Effect Transistor ("FET") and an N-channel FET constructed in a P-type substrate and having the P-channel FET in an N-type well region there is a vertical parasitic PNP transistor and a lateral parasitic NPN transistor. Under certain excitation conditions, the two interconnected parasitic bipolar transistors are triggered to act in combination like a PNPN structure creating a low resistance path between the positively biased source of the P-channel device and the negatively biased or grounded source of the N-channel device. The potentially large currents that can flow through this path can cause the destruction of the CMOS structure. The causes and effects of latch-up have been the subject of many technical articles and several solutions have been suggested for eliminating or reducing the effects of latch-up.

Since this latch-up phenomenon cannot take place if the current gain product of the two parasitic transistors is less than 1, most solutions to this problem involve schemes for reducing the current gains of the parasitic bipolar transistors.

In an article by B. L. Gregory and B. D. Shafer entitled "Latch-Up in CMOS Integrated Circuits," published in IEEE Trans. Nuc. Sci., NS-20, No. 6, pp. 293-299, December 1973, there are three suggested techniques for eliminating or reducing the effects of latch-up. They include the reduction of the lifetime of the minority carriers in the CMOS structure, variations in circuit layout and variations in CMOS processing to reduce the current gain product of the parasitic transistors to less than 1. In an article by R. S. Payne, W. N. Grant and W. J. Bertram, entitled "Elimination of Latch-Up in Bulk CMOS," published in the Technical Digest for the International Electron Devices Meeting in December 1980 in Washington, D.C., there is a discussion on the use of an N on a N+ epitaxial layer starting material to reduce the substrate resistance to a level which would pre-

clude a sustained SCR action. In U.S. Patent 4,318,750, issued on March 9, 1982, to Rai-Choudhury et al, there is a discussion of a technique for eliminating the latch-up by irradiating the circuit with high energy ions to provide low lifetime regions for lowering the gains of the parasitic transistors. In U.S. Patent 4,327,368, issued on April 27, 1982, to Uchida, there is described a CMOS structure which is fabricated on a semiconductor layer which layer forms with a supporting semiconductor body a PN junction. This PN junction is reversed biased during operation to suppress the latch-up phenomenon. In an article by M. Sugino, I. A. Akers and M. E. Rebeschini, entitled "CMOS Latch-Up Elimination Using Schottky Barrier PMOS," published in IEDM 1982 pp. 462-465, the CMOS structure uses Schottky barrier junctions for the source and drain of the P-channel transistor to eliminate the PNPN structure. The Schottky barriers are used to provide a low minority carrier injection into the MOSFET inversion layer which results in a lower gain for the parasitic bipolar transistors. Among the limitations of this structure is low P-channel FET gain resulting from the offset of the source and drain junctions from the gate electrode.

The approaches described above represent efforts to reduce the effectiveness of latch-up in CMOS devices. The present invention extends the developments in this area of technology while eliminating many of the disadvantages and limitations of prior art structures and offering many further advances and flexibilities, for example, simplicity and compatibility with existing conventional processes and CMOS circuits.

The invention as claimed generally solves the problem of how to provide an improved semiconductor contact structure. Particularly, it is to provide a means for preventing the latch-up effect in semiconductor devices having complementary type CMOS transistors. More particularly, the invention is to provide a contact structure which can be used in the source region of one or both of the CMOS transistors to prevent the latch-up effect in the CMOS structure.

To accomplish this purpose, we have provided a new semiconductor contact structure which, when incorporated in a CMOS circuit, lowers the gain product of its parasitic bipolar transistors. Our new semiconductor contact structure includes in a semiconductor layer of a first conductivity type, a degeneratively doped region of a first conductivity type and a second degeneratively doped region of a second conductivity type contiguously disposed to the first region so as to form a tunnel injecting interface between the two regions. It also has electrically conductive means contiguous to at least one of the two degeneratively doped regions. Such a contact is designed to connect two semiconductor regions of a different conductivity type to substantially the same potential level with one connection to a power source terminal.

Thus, in one embodiment of this invention, the new contact structure can be made by forming in a N-type semiconductor layer a first degeneratively doped region $P^{++}$, and a second degeneratively doped layer $N^{++}$ contiguous to the first region establishing a structure wherein under the proper biasing conditions charges can transfer from one region to the other as if the two opposite conductivity regions were an ohmic resistor of a relatively low absolute resistance value. For example, the two regions may form a $P^{++}N^{++}$ junction tunnel diode wherein under the proper biasing conditions with a very low voltage applied across the diode (in either forward or reverse biasing direction) charges will move across the junction from one region to the other by tunneling. When such a structure is used in the source of one or both transistors of a CMOS device it reduces the base spreading resistance of the parasitic bipolar transistor(s) and reduces their current gain product which in turn reduces the likelihood of latch-up for the device.

A CMOS device may be made having two complementary type FET's monolithically constructed in the same semiconductor body. One of these FET's is inside a well region which in turn is inside the semiconductor body and has a conductivity opposite to that of this body. Each FET has source, channel and drain regions and one of the two source regions is degeneratively doped. Contiguously disposed to this degeneratively doped source region is a degeneratively doped contact region having a conductivity type opposite to that of the degeneratively doped source region. A CMOS circuit can also be made, in accordance with the teachings of this invention, to have both source regions degeneratively doped and to have degeneratively doped contact regions contiguously disposed to both source regions.

Several ways of carrying out the invention are described in detail below with reference to drawings which illustrate only specific embodiments, in which:

Fig. 1 is a diagrammatic cross-sectional view of a prior art CMOS device.

Fig. 2 is an equivalent circuit of the parasitic bipolar transistors inherent in the CMOS structure shown in Fig. 1.

Fig. 3 is a diagrammatic cross-sectional view of a semiconductor device embodying the invention.

Fig. 4 is an illustration of the voltage current characteristics of tunnel diodes such as the one included in the device shown in Fig. 3.

Figs. 5a-5c are diagrammatic cross-sectional views of alternative contact structures that can be used for CMOS devices embodying the invention.

Fig. 6 is a diagrammatic cross-sectional view of a portion of yet another structure that can be used with CMOS devices embodying the invention.

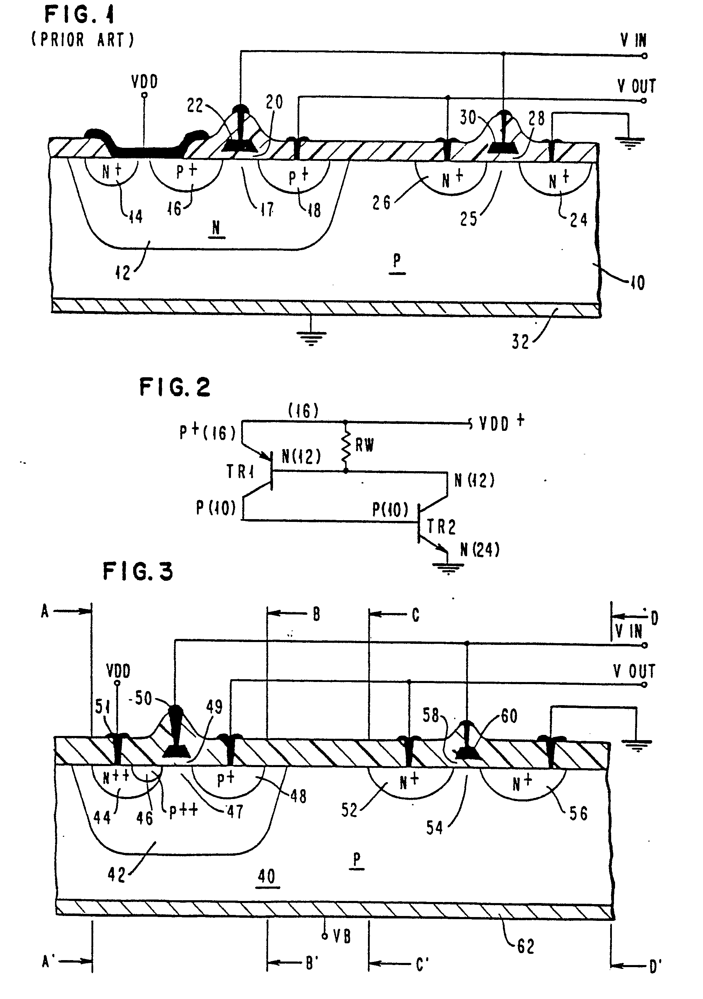

Referring now to Fig. 1, there is shown a diagrammatic cross-sectional view of a prior art CMOS device. It includes a silicon layer 10 having a P-type conductivity, a well region 12 with an N-type conductivity, an $N^+$ contact region 14 in the well region 12 and an adjacent $P^+$ source region 16. The first FET transistor of the device in the N-type well region, is a P-channel FET having source region 16, channel region 17, drain region 18, an insulating layer 20, and a gate electrode 22. The second FET is outside the well region but in the same layer 10. It is an N-channel FET and has source region 24, channel region 25, drain region 26, insulating layer 28 and gate electrode 30. The $N^+$ contact region 14 and the $P^+$ source region 16 are connected with a metal conductor which is in direct contact with both regions, to a power source terminal VDD. The voltage applied to that terminal is typically 5 to 10 volts. The gate electrodes 22 and 30 are commonly connected to input terminal V IN and the $P^+$ region 18 and the $N^+$ region 26 are commonly connected to an output terminal V OUT. The $N^+$ source region 24 is connected to a ground terminal or can be connected to some other preselected reference power source. The substrate 10 is connected through a contact region 32 to a terminal which can be grounded or set at a slightly negative bias potential.

Referring now to Fig. 2, there is shown the equivalent circuit of the parasitic bipolar transistor circuit inherent in the device shown in Fig. 1. The circuit includes a PNP transistor TR1, an NPN transistor TR2 and a resistor RW which represents the resistance between the emitter 16 and the base, as represented by regions 14 and 12. In certain prior art devices the $N^+$ contact region 14 and the $P^+$ source region 16 are made contiguous to each other to short out the base emitter junction of the PNP transistor. However, even in these devices there will still be some lateral resistance in the base region (well region 12), which at high injections can cause the current gain product of the two parasitic transistors to exceed 1. In addition, devices having contact regions adjacent to source regions and making contacts to both regions are more difficult to make because they require two high level diffusions, one for the formation of an $N^+$ region and the other for the formation of the $P^+$ region and then they require two contacts to be made to the VDD terminal line with at least one alignment between the two contacts.

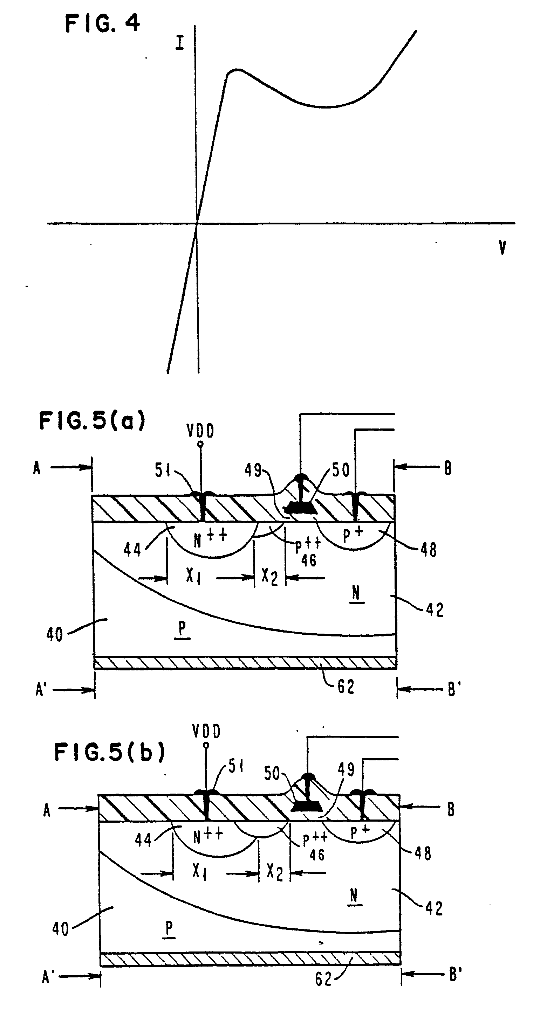

Referring now to Fig. 3, there is shown a CMOS device constructed in accordance with the teachings of the present invention. It includes a P-type silicon body 40 having a doping concentration on the order of $10^{15}$ dopant atoms/cm³, an N-type well region 42 having a doping concentration close to the surface in the range between $1 \times 10^{16}$ dopant atoms/cm³ to $2 \times 10^{16}$ dopant atoms/cm³, an $N^{++}$ contact region 44, a $P^{++}$ region 46 and a $P^+$ region 48 for the P-channel transistor's source and drain regions, respectively, a channel region 47, a gate dielectric 49, a gate electrode 50. Electrical conductive means 51, such as a metal contact, connect the contact region 44 to a power supply terminal VDD. The source region 46 is formed in the $N^{++}$ contact region through a very heavy doping of a preselected portion of the $N^+$ 50 contact region to overcompensate the $N^{++}$ and convert it into a $P^{++}$ region which is connected to a terminal line for application of a source bias potential. The doping of the $N^{++}$ contact region 44 and the $P^{++}$ region 46 is done as to create a $P^{++}N^{++}$ junction tunnel diode in the source region of the transistor. These types of diodes differ from conventional PN diodes by having much higher doping concentrations on both sides of the PN junction which gives them much higher conductivity within a small biasing range in either forward or reverse biasing direction. As the forward biasing is increased these diodes will exhibit a negative resistance within a certain biasing range and then as the forward biasing is increased the diode will exhibit the normal PN junction characteristics. A particular tunnel diode's exact characteristics depend on, among other factors, the semiconductor material from which the device was made. For a PN junction to have these types of characteristics it is necessary for both sides of the diode to be degeneratively doped. For example, doping concentrations in silicon for degeneratively doped regions 44 and 46 should be in excess of $1.8 \times 10^{19}$ dopant atoms/ $cm^3$. Descriptions of tunnel diode characteristics can be found in many textbooks, such as in "Introduction to Applied Solid State Physics" by Richard Darvin, published by Plenum Press in 1980. In pages 96 through 101 there is a discussion of tunnel diodes and the behavior of degenerate PN junctions under differing bias conditions. Furthermore, in a book by Helmut F. Wolf, entitled "Semiconductors" which was published by Wiley-Interscience in 1972, there is a chapter untitled "Degenerate and Nondegenerate Semiconductors" which describes the behavior of semiconductor materials at different doping levels. Thus, at the application of a small forward bias, electron energy states in the conductance band on the $N^{++}$ side of the $P^{++}N^{++}$ junction reach the same energy level as vacant energy states in the valence band on the $P^{++}$ side which increases the probability of electrons "tunneling through" the junction barrier. As the forward bias applied across the $P^{++}N^{++}$ junction increases, the overlap of the $N^{++}$ conduction band and the $P^{++}$ valance band disappears and minority carriers are injected across the junction giving rise to the normal PN junction characteristics as indicated in the curve shown in Fig. 4. During reverse biasing of the junction, holes will tunnel from the $N^{++}$ side of the diode to the $P^{++}$ side and electrons from the $P^+ +$ side to the $N^{++}$ side, creating a low impedance across the diode. This impedance is relatively low compared to the channel impedance of the P-channel transistor and will not affect the performance of the P-channel FET. However, the $P^{++}N^{++}$ diode shown in the structure of Fig. 3 is designed to have an injection efficiency for holes into the N well 42 which is extremely low by making the area of $P^{++}$ region 46 relatively small and by keeping the bias potential at the $N^{++}$ region 44 slightly higher than in the $P^{++}$ region. The tunnel diodes formed in contact structures made in accordance with the teachings of this invention are biased to operate in the linear portions of their operating characteristics shown in Fig. 4.

The remaining parts of the device shown in Fig. 3 are made through conventional processing techniques. The P-channel FET in the N-well region includes the $P^{++}$ region 46 mentioned above as the source, region 47 as the channel, region 48 as the drain, region 49 as the gate dielectric and region 50 as the gate electrode. The N-channel FET includes source region 56, channel region 54, drain region 52, gate dielectric region 58, and gate electrode 60. The drain region 48 of the P-channel FET and the drain region 52 of the N-channel FET are each connected through ohmic contact means to drain terminals which are commonly connected to an output terminal V OUT. The gate electrodes 50 and 60 of the two FET's are commonly connected to an input terminal V IN. The source region 56 of the N-channel FET is typically connected through ohmic contact means to ground. The $N^{++}$ contact region 44 is connected through an ohmic contact 51 to a power source terminal VDD. The substrate 40 is connected through a contact region 62 to terminal VB which is set either at ground or at a negative potential, typically in the range of -1 to -3 volts. VDD can be set to a potential of approximately 5 volts and during the operation of the P-channel transistor the $P^{++}$ source region will reach a slightly lower potential of about.4.95 to 4.90 volts so that the potential difference between the two will be less than 100 millivolts with the source region 46 at the lower potential.

The equivalent circuit shown in Fig. 2 represents the parasitic circuits of both the device of Fig. 1 and the device of Fig. 3. However, the parasitic SCR is effectively eliminated from the device shown in Fig. 3, because of the special construction of the source region of this device. The latch-up phenomenon takes place when the parasitic TR1 and TR2 are both conductive and they form a PNPN type structure. In the case of the device in Fig. 3, this PNPN structure should be through $P^{++}$ source region 46, N-well region 42, P-type substrate 40 and $N^+$ source region 56. However, in the device of Fig. 3, the $P^{++}$ source region 46 which is also the emitter of the bipolar transistor TR1 has been cut down in size to reduce to current gain of TR1. Furthermore, by having regions 44 and 46 degeneratively doped with the $N^{++}$ contact region 44 at the same or slightly higher potential than the $P^{++}$ source region 46, the base spreading resistance RW will be substantially lower. This causes the current gain of TR1 to be reduced and the parasitic SCR is effectively eliminated.

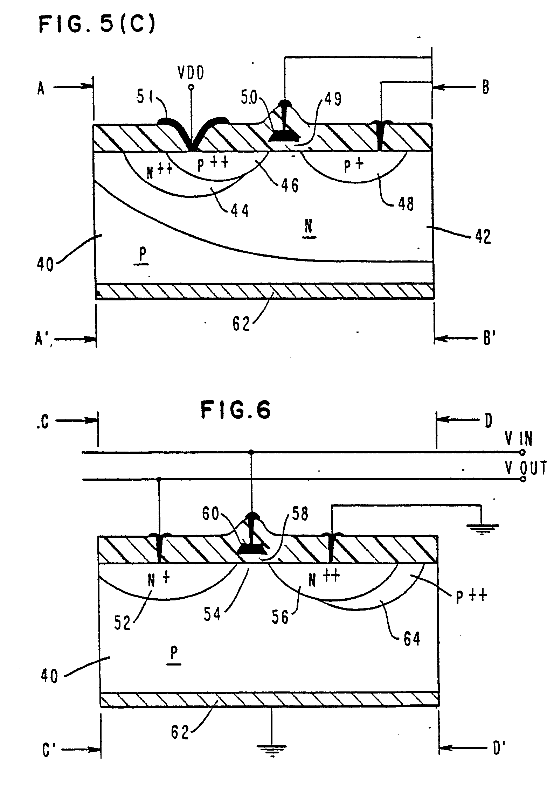

Referring now to Figs. 5a-5c, there are shown alternative tunnel injectors formed by altering the relative position and size of the $N^{++}$ contact region and the $P^{++}$ source region. These are alternative structures to the structure shown in Fig. 3 between lines AA' and BB'. In both Fig. 5a and Fig. 5b the length of the source region $X_2$ should be less than the length $X_1$ of the contact region in order to minimize the size of the source region and thus the size of the emitter of the parasitic transistor which minimizes the injection efficiency of holes from the source region into the N well region. Any one of these structures shown with an FET having a contact structure in accordance with the teachings of this invention can be used either as part of a CMOS arrangement or separately.

Referring now to Fig. 6, there is shown another alternative structure to that shown in Fig. 3 between lines CC' and DD'. This shows the N-channel transistor of the CMOS shown in Fig. 3 with a contact structure in accordance with the teachings of this invention at its source region 56. Region 56 is a $N^{++}$ degeneratively doped region and region 64 is a $P^{++}$ degeneratively doped region. If this structure is used in the device of Fig. 3 then contact region 62 must be connected to ground.

## Claims

1. A semiconductor structure with at least one FET including a channel region (47) of a first conductivity type interposed between source and drain regions (46, 48) of a second conductivity type formed in a semiconductor layer (42) of a first conductivity type, and a gate electrode (60) adjacent to and insulated from said channel region by a gate dielectric layer (49), characterized in that said source region is a degeneratively doped region (46), that a degeneratively doped contact region (44) of a first conductivity type is contiguously disposed to said source region (46) the area of said source region being smaller than that of said contact region thereby minimizing the emitter size of a related parasitic transistor structure, that said source and said contact region form a tunnel diode structure, and that ohmic contact means (51) are provided on one of said source and contact regions (44, 46) for electrically connecting both source and contact regions to a power source terminal (VDD) such that the thus formed tunnel diode structure is biased to operate in its linear portion of its operating characteristics.

2. A semiconductor structure as set forth in claim 1 wherein said semiconductor layer of a first conductivity type is a well region (42) in a semiconductor body (40) of a second conductivity type.

3. A semiconductor structure as set forth in claim 1 further including a second FET complementary to said first FET with said second FET having a channel region (54) of a second conductivity type interposed between source and drain regions (56, 52) of a first conductivity type formed in a predetermined portion of said semiconductor body (40) outside said well region (42), a gate electrode (60) adjacent said semiconductor region and spatially disposed over said channel region and insulated from said semiconductor region by a gate dielectric layer (58); means for interconnecting said first FET and said second FET to form a CMOS circuit arrangement; means for biasing said first FET including said power source terminal, said second FET and said semiconductor body to cause charges to move across said degenerate junction by tunneling and thereby preventing latch-up in the structure.

4. A semiconductor structure as set forth in claim 3 wherein said source region (56) of said second FET is a degeneratively doped region of a first conductivity type and said semiconductor structure further includes a degeneratively doped contact region (64) of a second conductivity type contiguously disposed to said source region (56) of said second FET so as to form a degenerate PN junction therebetween.

5. A semiconductor structure of the type having two complementary type FET's monolithically constructed in a semiconductor body (40) of a given conductivity type, with one FET formed in a well region (42) in said semiconductor body (40) having a conductivity opposite to that of said semiconductor body and with each FET having source, channel and drain regions characterized in that at least one of said FET source regions (46, 56) is a degeneratively doped region and contiguously disposed to said degeneratively doped source region is a degeneratively doped contact region (44, 64) having a conductivity type opposite to that of said degeneratively doped source region the area of said source region being smaller than that of said contact region so that under the proper biasing conditions charges can transfer between said degeneratively doped source and contact regions by tunneling and that both degeneratively doped contiguous regions are biased with one connection to a power supply terminal such that the thus formed tunnel diode structure is operated in its linear portion of its operating characteristics preventing a parasitic latch-up phenomenon.

6. A semiconductor structure as set forth in one or more of the preceding claims wherein the degenerate doping concentration in silicon is in excess of $1.8 \times 10^{19}$ dopant atoms/cm$^3$.

7. A semiconductor structure as in claim 6 with the doping concentration of the semiconductor body (40) being in the order of $10^{15}$/cm$^3$ and of the well region (42) being (close to the surface) in the range between $1 \times 10_1^6$ to $2 \times 10^{16}$/cm$^3$.

8. A semiconductor structure as set forth in one or more of the preceding claims, particularly according to claim 5. wherein the effective length ($X_2$ in figs. 5a, 5b of the source region (46) is less than the length ($X_1$) of the corresponding contact region (44).

## Patentansprüche

1. Halbleiterstruktur mit mindestens einem FET mit einer Kanalzone (47) eines ersten Leitfähigkeitstyps zwischen Source und Drain (46, 48) eines zweiten Leitfähigkeitstyps in einer Halbleiterschicht (42) eines ersten Leitfähigkeitstyps, und mit einer Gate-Elektrode (60), die neben der Kanalzone liegt und von dieser durch ein Gate-Dielektrikum (49) isoliert ist, dadurch gekennzeichnet, daß die Source eine entartet dotierte Zone (46) ist, daß eine entartet dotierte Kontaktzone (44) eines ersten Leitfähigkeitstyps neben der Source (46) vorgesehen ist, wobei der Bereich der Zone kleiner ist als der der Kontaktzone, so daß die Emittergröße einer zugeordneten parasitären Transistorstruktur auf ein Mindestmaß reduziert wird, daß diese Source und diese Kontaktzone eine Tunneldiodenstruktur bilden, und daß Ohm'sche Kontakte (51) auf einer der Source- und Kontaktzonen (44, 46) vorgesehen sind, um sowohl Source- als auch Kontaktzonen mit einem Stromquellen-Terminal (VDD) elektrisch zu verbinden, so daß die so gebildete Tunneldiodenstruktur zum Betrieb im linearen Arbeitsbereich vorgespannt wird.

2. Halbleiterstruktur nach Anspruch 1, bei welcher die Halbleiterschicht eines ersten Leitfähigkeitstyps ein Gebiet (42) in einem Halbleiterkörper (40) eines zweiten Leitfähigkeitstyps ist.

3. Halbleiterstruktur nach Anspruch 1, welche weiterhin einen dem ersten FET komplementären zweiten FET enthält, der eine Kanalzone (54) eines zweiten Leitfähigkeitstyps zwischen Source und Drain (56, 52) eines ersten Leitfähigkeitstyps in einem bestimmten Teil des Halbleiterkörpers (40) außerhalb des Gebiets (42) aufweist, sowie eine Gate-Elektrode (60), die neben der Halbleiterzone und räumlich über der Kanalzone vorgesehen und von der Halbleiterzone durch ein Gate-Dielektrikum (58) isoliert ist; mit Mitteln zum Verbinden des ersten FET mit dem zweiten FET, um eine CMOS-Schaltungsanordnung zu formen; mit Mitteln zum Vorspannen des ersten FET mit dem Stromquellen-Terminal, wobei der zweite FET und der Halbleiterkörper Ladungen über den entarteten Übergang durch Tunneln bewegen und dadurch eine Verriegelung (latch-up) in der Struktur verhindern.

4. Halbleiterstruktur nach Anspruch 3, bei der die Source (56) des zweiten FET eine entartet dotierte Zone eines ersten Leitfähigkeitstyps ist, und die außerdem eine entartet dotierte Kontaktzone (64) eines zweiten Leitfähigkeitstyps neben der Source (56) des zweiten FET aufweist, um einen PN-Übergang dazwischen zu bilden.

5. Halbleiterstruktur des Typs mit zwei komplementären FET's, die monolithisch in einem Halbleiterkörper (40) eines gegebenen Leitfähigkeitstyps gebildet sind, wobei ein FET in einem Gebiet (42) im Halbleiterkörper (40) ausgebildet ist und eine Leitfähigkeit aufweist, die der des Halbleiterkörpers entgegengesetzt ist, und wobei jeder FET Source-, Kanal- und Drain-Zonen aufweist,

dadurch gekennzeichnet, daß mindestens eine der FET-Source-Zonen (46, 56) eine entartet dotierte Zone ist, und daß neben der entartet dotierten Source eine entartet dotierte Kontaktzone (44, 64) von einem Leitfähigkeitstyp vorgesehen ist, der demjenigen der entartet dotierten Source entgegengesetzt ist, und wobei der Bereich der Source kleiner ist als der der Kontaktzone, so daß unter korrekten Vorspannungsbedingungen Ladungen durch Tunneln zwischen den entartet dotierten Source- und Drainzonen transferiert werden können, und daß beide entartet dotierten nebeneinanderliegenden Zonen mit einer Verbindung mit einem Stromquellen-Terminal vorgespannt sind, so daß die so gebildete Tunneldiodenstruktur im linearen Teil ihres Arbeitsbereichs betrieben wird und damit ein parasitäres Verriegelungs (latch-up)-Phänomen verhindert.

6. Halbleiterstruktur nach einem oder mehreren der vorhergehenden Ansprüche, bei der die entartete Dotierungskonzentration in Silizium mehr als $1,8 \times 10^{19}$ Dotierungsatome/cm$^3$ beträgt.

7. Halbleiterstruktur nach Anspruch 6, bei der die Dotierungskonzentration des Halbleiterkörpers (40) in der Größenordnung von $10^{15}$/cm$^3$ und die des Gebietes (42) (nahe der Oberfläche) in der Größenordnung zwischen $1 \times 10^{16}$ und $2 \times 10^{16}$/cm$^3$ liegt.

8. Halbleiterstruktur nach einem oder mehreren der vorhergehenden Ansprüche, insbesondere nach Anspruch 5, bei der die effektive Länge ($X_2$ in Fign. 5a, 5b) der 2 Source (46) kleiner als die Länge ($X_1$) der entsprechenden Kontaktzone (44) ist.

**Revendications**

1. Structure de semiconducteur comprenant au moins un transistor FET comportant une région de canal (47) possédant un premier type de conductivité et intercalée entre des régions de source et de drain (46,48) possédant un second type de conductivité et formées dans une couche semiconductrice (42) possédant un premier type de conductivité, et une électrode de grille (60) voisine de ladite région de canal et isolée par rapport à cette dernière par une couche diélectrique de grille (49), caractérisée en ce que ladite région de source est une région (46) dopée d'une manière dégénérée, qu'une région de contact (44) dopée d'une manière dégénérée et possédant un premier type de conductivité est disposée de manière à être contiguë à ladite région de source (46), dont la surface est inférieure à celle de ladite région de contact, ce qui réduit la taille de l'émetteur d'une structure associée de transistor parasite, que ladite région de source et ladite région de contact forment une structure de diode tunnel et que des moyens de contact ohmiques (51) sont prévus sur l'une ou l'autre de ladite région de source (44) et de ladite région de contact (46) pour raccorder électriquement à la fois la région de source et la région de contact à une borne (VDD) d'une source d'alimentation en énergie de telle sorte que la structure de diode tunnel ainsi formée est polarisée de manière à fonctionner dans la partie linéaire de sa caractéristique de fonctionnement.

2. Structure de semiconducteur selon la revendication 1, dans laquelle ladite couche semiconductrice possédant un premier type de conductivité est une région de puits (42) formée dans un corps semiconducteur (40) possédant un second type de conductivité.

3. Structure de semiconducteur selon la revendication 1, comportant en outre un second transistor FET complémentaire dudit premier transistor FET, ledit second transistor FET comportant une région de canal (54) possédant un second type de conductivité et intercalée entre les régions de source et de drain (56, 52) possédant un premier type de conductivité et formées dans une partie prédéterminée dudit corps semiconducteur (40) à l'extérieur de ladite région de puits (42), une électrode de grille (60) située au voisinage de ladite région semiconductrice et disposée dans l'espace au-dessus de ladite région de canal et isolée de ladite région semiconductrice par une couche diélectrique de grille (58); des moyens pour interconnecter ledit premier transistor FET et ledit second transistor FET de manière à former un agencement de circuit CMOS; des moyens pour polariser ledit premier transistor FET, incluant ladite borne de la source d'alimentation en énergie, ledit second transistor FET et ledit corps semiconducteur de manière à amener les charges à traverser ladite jonction dégénérée, par effet tunnel et empêcher de ce fait l'effet de verrouillage dans la structure.

4. Structure de semiconducteur selon la revendication 3, dans laquelle ladite région de source (56) dudit second transistor FET est une région dopée d'une manière dégénérée possédant un premier type de conductivité, et ladite structure semiconductrice comporte en outre une région de contact (64) dopée d'une manière dégénérée, possédant un second type de conductivité et disposée de manière à être contiguë à ladite région de source (56) dudit second transistor FET de manière à former avec cette région une jonction PN dégénérée.

5. Structure de semiconducteur du type comportant deux transistors FET de type complémentaire formés de façon monolithique dans un corps semiconducteur (40) possédant un type de conductivité donné et dont l'un est formé dans une région de puits (42) dudit corps semiconducteur (40) possédant une conductivité opposée à celle dudit corps semiconducteur, chacun des transistors FET possédant des régions de source, de canal et de drain, caractérisée en ce qu'au moins l'une desdites régions de source (46,56) des transistors FET est une région dopée d'une manière dégénérée et est située dans une position contiguë à ladite région de source dopée d'une manière dégénérée tandis que dans une position contiguë à ladite région de source dopée d'une manière dégénérée se trouve disposée une région de contact (44, 44) dopée d'une manière dégénérée et possédant un type de conductivité opposé à celui de ladite région de source dopée d'une manière dégénérée, la surface de ladite région de source étant inférieure à celle de ladite région de contact de sorte que dans les conditions appropriées de polarisation, un transfert de charges peut s'effectuer entre ladite région de source et ladite région de contact, dopées d'une manière dégénérée, par effet tunnel et que les deux régions contiguës dopées d'une manière dégénérées sont polarisées au moyen d'une connexion de liaison à une borne d'une source d'alimentation en énergie de telle sorte que la structure de diodes tunnels ainsi formée fonctionne dans la partie linéaire de sa caractéristique de fonctionnement, ce qui empêche un phénomène de verrouillage parasite.

6. Structure de semiconducteur selon une ou plusieurs des revendications précédentes, dans laquelle la concentration de dopage dégénéré dans le silicium dépasse $1,8 \times 10^{19}$ atomes de substance dopante/$cm^3$.

7. Structure de semiconducteur selon la revendication 6, dans laquelle la concentration de dopage du corps semiconducteur (40) est de l'ordre de $10^{15}/cm^3$ et la concentration de dopage de la région de puits (42) est (à proximité de la surface) située dans la gamme comprise entre $1 \times 10^{16}$ et $2 \cdot 10^{16}/ \times cm^3$.

8. Structure de semiconducteur selon une ou plusieurs des revendications précédentes, notamment selon la revendication 5, dans laquelle la longueur effective ($X_2$ sur les figures 5a, 5b) de la région de source (46) est inférieure à la longueur ($X_1$) de la région de contact correspondante (44).

# FIG. 1
(PRIOR ART)

# FIG. 2

# FIG. 3

**F I G. 4**

**F I G.5(a)**

**F I G.5(b)**

## FIG. 5(C)

## FIG.6